# EUROPÄISCHE PATENTSCHRIFT

(11) **EP 1 309 089 B1**
(45) Veröffentlichungstag und Bekanntmachung des Hinweises auf die Patenterteilung: **20.06.2007**
(21) Anmeldenummer: 01440351.3
(22) Anmeldetag: 22.10.2001
(51) Int. Cl.: H03K 17/687, H03K 17/689, B61L 7/06, H03K 17/0812

(54) **Leistungsschalter zur Steuerung des Motors eines Weichenantriebs**
Power switch for controlling point motor drive
Commutateur de puissance pour la commande du moteur d'une commande d'aiguillage

(43) Veröffentlichungstag der Anmeldung: 07.05.2003
(73) Patentinhaber: Alcatel Transport Solutions Holding GmbH, 70435 Stuttgart (DE)
(72) Erfinder: Klose, Bernd, 71679 Asperg (DE)
(74) Vertreter: Kohler Schmid Möbus

(56) Entgegenhaltungen:
- DE-A- 3 445 340
- DE-A- 3 723 786
- US-A- 5 999 387
- PATENT ABSTRACTS OF JAPAN vol. 1999, no. 13, 30. November 1999 (1999-11-30) & JP 11 225055 A (SHARP CORP), 17. August 1999 (1999-08-17)

## Beschreibung

Die Erfindung betrifft einen Leistungsschalter, insbesondere zur Steuerung des Motors eines Weichenantriebs.

Der Motor im Eisenbahn-Weichenantrieb ist in der Regel ein 400 Volt Drehstrom Asynchronmotor. Beim Einschalten ist ein hoher Anlaufstrom zu schalten, beim Abschalten entstehen hohe Induktionsspannungen. Diese Beanspruchung führt an den eingesetzten Relais zu Verschleiß an den Kontakten.

Aufgabe der Erfindung ist es, einen verschleißfreien, zuverlässigen Schalter zu schaffen.

Gelöst wird diese Aufgabe durch einen erfindungsgemäßen Leistungsschalter gemäß Patentanspruch 1.

Zum verschleißfreien Schalten von Lasten sind Halbleiter eingesetzt. Diese sind bei Kurzschlüssen zwar sehr empfindlich und werden in der Regel sehr häufig zerstört. Da im Versorgungsnetz die Anstiegsgeschwindigkeit des Kurzschlussstromes durch induktive Komponenten aber begrenzt ist, kann der Leistungsschalter bei Kurzschluss schnell abgeschaltet werden, wodurch eine Zerstörung vermieden wird. Das Dokument DE-A-3 445 340 veröffentlicht ein Leistungsschalter.

Der Halbleiter-Leistungsschalter ist zur Steuerung des Weichenmotors einsetzbar. Er schaltet Kurzschlussströme zerstörungsfrei ab. Damit erreicht der Halbleiterschalter eine höhere Zuverlässigkeit als ein Relais.

Durch den Einsatz eines schnellen Halbleiterschalters besteht die Möglichkeit, zu bestimmten Phasenlagen der Versorgungsspannung zu schalten. Damit verringern sich Induktionsspannungen und elektromagnetische Störaussendungen.

Zur Absicherung von Kurzschluss ist keine Schmelzsicherung mehr erforderlich, folglich kann eine solche auch nicht mehr abschmelzen.

Vorteilhafte Eigenschaften sind den abhängigen Ansprüchen und der nachfolgenden Beschreibung zu entnehmen.

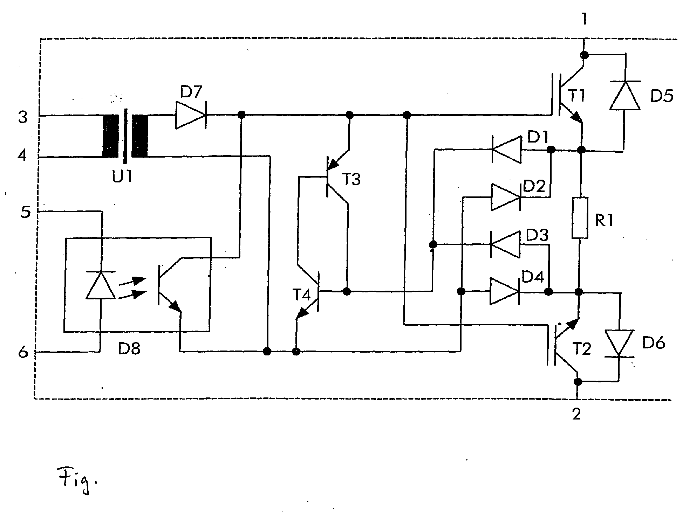

Im folgenden wird ein Ausführungsbeispiel der Erfindung anhand einer Figur erläutert. Die Figur zeigt eine schematische Darstellung eines Leistungsschalters.

Der Leistungsschalter wird insbesondere zur Steuerung des Motors eines Weichenantriebs eingesetzt, kann aber auch für Steuerungen jeden beliebigen Motors oder Generators verwendet werden.

Der Leistungsschalter dient zum Schalten einer Wechselspannung zwischen den Punkten 1 und 2. Zum Schalten von Drehstrom sind mindestens zwei derartige Leistungsschalter erforderlich.

Transistoren T1 und T2 schalten jeweils eine Halbwelle der Wechselspannung. Beide Transistoren T1 und T2 sind jeweils als Halbleiter-Transistor ausgeführt, z.B. als Feldeffekt-Transistoren JFET, MESFET oder MOSFET. Transistoren T1 und T2 sind in Reihe geschaltet, ihre Steuereingänge (=Gates) sind miteinander verbunden.

Zwischen den Punkten 1 und 2 ist die Reihenschaltung aus Transistor T1, ohmschen Widerstand R1 und Transistor T2 geschaltet. Der Wert des Widerstands R1 ist entsprechend den Eigenschaften des anzusteuernden Motors zu dimensionieren. Parallel zu Transistor T1 ist Diode D5 geschaltet, parallel zu Transistor T2 Diode D6.

Der Leistungsschalter wird über die Punkte 3 und 4 eingeschaltet und über die Punkte 5 und 6 ausgeschaltet. Punkte 3 und 4 sind mit der Primärwicklung eines Übertragers U1 verbunden. Punkte 5 und 6 sind mit den Eingängen eines Opto-Kopplers D8 verbunden.

Die Sekundärwicklung des Übertragers U1 ist zum einen über Diode D7 mit dem einen Ausgang des Opto-Kopplers D8 und den Steuereingängen der Transistoren T1 und T2 und zum anderen mit dem anderen Ausgang des Opto-Kopplers D8 verbunden.

Des weiteren ist eine Thyristor-Nachbildung beinhaltend Transistoren T3 und T4 vorgesehen. Transistor T3 ist ein pnp-Transistor, Transistor T4 ein npn-Transistor. Der Emitter des Transistors T3 ist mit den Steuereingängen der Transistoren T1 und T2 verbunden, der Kollektor mit dem Steuereingang von Transistor T4. Der Kollektor des Transistors T4 ist mit dem Steuereingeng des Transistors T3 verbunden, der Emitter mit dem anderen Ausgang des Opto-Kopplers D8.

Ferner ist eine nachgebildete Grätz-Brücke beinhaltend Dioden D1, D2, D3, D4 vorgesehen. Die Anode von Diode D1 ist mit dem Source-Anschluss von Transistor T1 verbunden, die Katode mit dem Steuereingang von Transistor T4. Die Anode von Diode D2 ist mit dem anderen Ausgang des Opto-Kopplers D8 verbunden, die Katode mit der Anode von Diode D1. Die Anode von Diode D3 ist mit dem Source-Anschluss des Transistors T2 verbunden, die Katode mit der Katode der Diode D1. Die Anode von Diode D4 ist mit der Anode der Diode D2 verbunden, die Katode mit der Anode der Diode D3. Die Anode von Diode D5 ist mit der Anode von Diode D1 verbunden, die Katode mit Punkt 1 und dem Drain-Anschluss des Transistors T1. Die Anode von Diode D6 ist mit der Anode der Diode D3 verbunden, die Katode mit Punkt 2 und dem Drain-Anschluss des Transistors T2.

Die Transistoren T1 und T2 schalten jeweils eine Halbwelle der Wechselspannung.

Durch Anlegen einer Steuerwechselspannung, z.B. ca. 100 kHz, an die Punkte 3 und 4, die durch Diode D7 gleichgerichtet wird, wird eine Steuerspannung für die Transistoren T1 und T2 erzeugt. Punkte 3 und 4 dienen somit als Steuereingänge zum Anschalten des Leistungsschalters.

Ein schnelles Abschalten wird durch Anlegen einer Gleichspannung an die Punkte 5 und 6 erreicht. Über Opto-Koppler D8 werden dann die Gate-Source-Kapazitäten der Transistoren T1 und T2 schnell entladen. Punkte 5 und 6 dienen somit als Steuereingänge zum Abschalten des Leistungsschalters.

Fließt zwischen den Punkten 1 und 2 ein Kurzschlussstrom, so bedingt dieser einen Spannungsabfall an Widerstand R1, der wiederum zum Überschreiten der Schwellspannung am Transistor T4 führt. Daraufhin zündet der durch Transistoren T3 und T4 nachgebildete Thyristor und folglich bricht die Gate-Spannung an den Transistoren T1 und T2 auf z.B. ca. 1 Volt zusammen. Dies führt zum Abschalten der Transistoren T1 und T2.

Erst nach Abschalten der Steuerwechselspannung an den Punkten 3 und 4 werden die Transistoren T3 und T4 gelöscht.

Die aus den Dioden D1 bis D4 gebildete Grätz-Brücke sichert, dass Kurzschlussströme beider Halbwellen zur Abschaltung führen.

Anstelle eines Opto-Kopplers D8 kann auch ein anderes Bauelement zur galvanischen Trennung verwendet werden. Anstelle eines Übertragers U1 kann auch ein anderes Bauelement zur galvanischen Trennung verwendet werden. Anstelle eines Thyristors aus den Transistoren T3 und T4 kann auch ein anders aufgebaute Thyristor verwendet werden. Anstelle der Feldeffekt-Transistoren T1 und T2 können auch andere Halbleiter-Transistoren verwendet werden, insbesondere auch bipolare Transistoren oder IGBT-Transistoren; IGBT=Isolated Gate Bipolar Transistor. Ein IGBT-Transistor ist eine Kombination eines MOS-Transistors und eines Bipolartransistors.

## Patentansprüche

1. Leistungsschalter, insbesondere zur Steuerung des Motors eines Weichenantriebs, mit zwei in Reihe geschalteten Feldeffekt-Transistoren (T1, T2), deren Steuereingänge und deren Source-Anschlüsse miteinander verbunden sind, wobei jedem FeldeffektTransistor (T1, T2) eine Diode (D5, D6) derart parallel geschaltet ist, dass die Anode mit dem Source-Anschluss verbunden ist,
**dadurch gekennzeichnet,**
**dass** ein Thyristor (T3, T4) vorgesehen ist, der mit den Steuereingängen der Feldeffekt-Transistoren (T1, T2) verbunden ist.

2. Leistungsschalter nach Anspruch 1, **dadurch gekennzeichnet, dass** zwischen den Source-Anschlüssen der Feldeffekt-Transistoren (T1, T2) ein ohmscher Widerstand (R1) geschaltet ist.

3. Leistungsschalter nach Anspruch 1, **dadurch gekennzeichnet, dass** eine Reihenschaltung aus einem Übertrager (U1) und einer Diode (D7) vorgesehen ist, wobei die Katode der Diode (D7) mit den Steuereingängen der Feldeffekt-Transistoren (T1, T2) verbunden ist.

4. Leistungsschalter nach Anspruch 1, **dadurch gekennzeichnet, dass** ein Opto-Koppler (D8) vorgesehen ist, der mit den Steuereingängen der Feldeffekt-Transistoren (T1, T2) verbunden ist.

5. Leistungsschalter nach Anspruch 1, **dadurch gekennzeichnet, dass** der Thyristor (T3, T4) aus zwei Halbleiter-Transistoren gebildet ist, wobei der eine als npn-Transistor und der andere als pnp-Transistor ausgeführt ist, dass der Kollektor des npn-Transistors mit dem Steuereingang des pnp-Transistors verbunden ist, und dass der Kollektor des pnp-Transistors mit dem Steuereingang des npn-Transistors verbunden ist.

6. Leistungsschalter nach Anspruch 1, **dadurch gekennzeichnet, dass** der Thyristor (T3, T4) einen positiven Anschluss, einen negativen Anschluss und einen Steuereingang aufweist, wobei der positive Anschluss mit den Steuereingängen der Feldeffekt-Transistoren (T1, T2) verbunden ist, dass vier Dioden (D1, D2, D3, D4) vorgesehen sind, wobei die Anode der ersten Diode (D1), die Katode der zweiten Diode (D2) und der Source-Anschluss des einen Feldeffekt-Transistors (T1) miteinander verbunden sind, dass die Anode der dritten Diode (D3), die Katode der vierten Diode (D4) und der Source-Anschluss des anderen Feldeffekt-Transistors (T2) miteinander verbunden sind, dass die Katode der ersten Diode (D1) und die Katode der dritten Diode (D3) mit dem Steuereingang des Thyristors (T3, T4) verbunden sind, und dass die Anode der zweiten Diode (D2) und die Anode der vierten Diode (D4) mit dem negativen Anschluss des Thyristors (T3, T4) verbunden sind.

7. Leistungsschalter nach Anspruch 1, **dadurch gekennzeichnet, dass** anstelle der Feldeffekt-Transistoren (T1, T2) IGBT-Transistoren oder bipolare Transistoren verwendet sind.

## Claims

1. Power switch, particularly for controlling a point motor drive, with two field effect transistors (T1, T2) connected in series, the control inputs and source connections of which are connected to each other, in which a diode (D5, D6) is connected in parallel to each field effect transistor (T1, T2) in such a way that the anode is connected to the source connection,
**characterised in that**
a thyristor (T3, T4) is provided, which is connected to the control inputs of the field effect transistors (T1, T2).

2. Power switch according to claim 1, **characterised in that** an ohmic resistance (R1) is connected between the source connections of the field effect transistors (T1, T2).

3. Power switch according to claim 1, **characterised in that** a series connection of a transformer (U1) and a diode (D7) is provided, in which the cathode of the diode (D7) is connected to the control inputs of the field effect transistors (T1, T2).

4. Power switch according to claim 1, **characterised in that** an optocoupler (D8) is provided, which is connected to the control inputs of the field effect transistors (T1, T2).

5. Power switch according to claim 1, **characterised in that** the thryistor (T3, T4) is made of two semiconductor transistors, in which one is made as an npn transistor and the other as a pnp transistor, so that the commutator of the npn transistor is connected to the control input of the pnp transistor, and the commutator of the pnp transistor is connected to the control input of the npn transistor.

6. Power switch according to claim 1, **characterised in that** the thyristor (T3, T4) has a positive connection, a negative connection and a control input, in which the positive connection is connected to the control inputs of the field effect transistors (T1, T2), four diodes (D1, D2, D3, D4) are provided, in which the anode of the first diode (D1), the cathode of the second diode (D2) and the source connection of one field effect transistor (T1) are connected to each other, the anode of the third diode (D3), the cathode of the fourth diode (D4) and the source connection of the other field effect transistor (T2) are connected to each other, the cathode of the first diode (D1) and the cathode of the third diode (D3) are connected to the control input of the thyristor (T3, T4) and the anode of the second diode (D2) and the anode of the fourth diode (D4) are connected to the negative connection of the thyristor (T3, T4).

7. Power switch according to claim 1, **characterised in that** IGBT transistor or bipolar transistors are used instead of the field effect transistors (T1, T2).

## Revendications

1. Commutateur de puissance, en particulier pour la commande du moteur d'une commande d'aiguillage, comprenant deux transistors à effet de champ (T1, T2) montés en série, dont les entrées de commande et dont les branchements de source sont reliés entre eux, une diode (D5, D6) étant montée en parallèle avec chaque transistor à effet de champ (T1 et T2) de telle sorte que l'anode est reliée au branchement de la source, **caractérisé en ce que** un thyristor (T3, T4) est prévu, lequel est relié aux entrées de commande des transistors à effet de champ (T1 et T2).

2. Commutateur de puissance selon la revendication 1, **caractérisé en ce qu'**une résistance (R1) ohmique est montée entre les branchements de source des transistors à effet de champ (T1, T2).

3. Commutateur de puissance selon la revendication 1, **caractérisé en ce qu'**un montage en série constitué d'un transmetteur (U1) et d'une diode (D7) est prévu, la cathode de la diode (D7) étant reliée aux entrées de commande des transistors à effet de champ (T1, T2).

4. Commutateur de puissance selon la revendication 1, **caractérisé en ce qu'**un optocoupleur (D8) est prévu, lequel est relié aux entrées de commande des transistors à effet de champ (T1, T2).

5. Commutateur de puissance selon la revendication 1, **caractérisé en ce que** le thyristor (T3, T4) est constitué de deux transistors à semi-conducteurs, l'un étant conçu comme transistor npn et l'autre comme transistor pnp, **en ce que** le collecteur du transistor npn est relié à l'entrée de commande du transistor pnp, et **en ce que** le collecteur du transistor pnp est relié à l'entrée de commande du transistor npn.

6. Commutateur de puissance selon la revendication 1, **caractérisé en ce que** le thyristor (T3, T4) présente un branchement positif, un branchement négatif et une entrée de commande, le branchement positif étant relié aux entrées de commande des transistors à effet de champ (T1, T2), **en ce que** quatre diodes (D1, D2, D3, D4) sont prévues, l'anode de la première diode (D1), la cathode de la seconde diode (D2) et le branchement de source d'un transistor à effet de champ (T1) étant reliés entre eux, **en ce que** l'anode de la troisième diode (D3), la cathode de la quatrième diode (D4) et le branchement de source de l'autre transistor à effet de champ (T2) sont reliés entre eux, **en ce que** la cathode de la première diode (D1) et la cathode de la troisième diode (D3) sont reliées à l'entrée de commande du thyristor (T3, T4) et **en ce que** l'anode de la seconde diode (D2) et l'anode de la quatrième diode (D4) sont reliées au branchement négatif du thyristor (T3, T4).

7. Commutateur de puissance selon la revendication 1, **caractérisé en ce que** des transistors IGBT ou des transistors bipolaires sont utilisés au lieu des transistors à effet de champ (T1, T2).
